(19) Europäisches Patentamt

European Patent Office

Office européen des brevets

(11) Veröffentlichungsnummer: **0 245 787**
**A1**

(12) **EUROPÄISCHE PATENTANMELDUNG**

(21) Anmeldenummer: **87106660.1**

(22) Anmeldetag: **07.05.87**

(51) Int. Cl.⁴: **G01R 1/067**

(30) Priorität: **12.05.86 DE 3615935**

(43) Veröffentlichungstag der Anmeldung:
**19.11.87 Patentblatt 87/47**

(84) Benannte Vertragsstaaten:
**AT CH DE FR IT LI**

(71) Anmelder: **Feinmetall Gesellschaft mit
beschränkter Haftung
Zeppelinstrasse 2
D-7033 Herrenberg(DE)**

(72) Erfinder: **Giringer, Klaus
Ehbühl 14
D-7033 Herrenberg(DE)**

(74) Vertreter: **König, Oskar, Dr.-Ing. Dipl.-Phys.
Klüpfelstrasse 6 Postfach 51
D-7000 Stuttgart 1(DE)**

(54) **Federkontaktstift.**

(57) Federkontaktstift für Prüfvorrichtungen zum Prüfen von elektrischen Prüflingen. Der Federkontaktstift weist einen Zylinder auf, in dem der Kolben eines federbelasteten Kontaktbolzens gleitbar gelagert ist. Die zum Gleiten auf der Laufbahn des Zylinders befindliche, mindestens eine Gleitfläche des Kolbens ist zur Verringerung des Verschleißes ballig ausgebildet und der Kontaktbolzen ist zumindest in seiner vorderen Ruhestellung zum Zylinder zentriert.

FIG.1

EP 0 245 787 A1

## Federkontaktstift

Die Erfindung betrifft einen Federkontaktstift für Prüfvorrichtungen, die dem Prüfen von elektrischen, insbesondere elektronischen Prüflingen, wie Leiterplatten oder dergl., dienen.

Prüfvorrichtungen dieser Art sind bekannt (z. B. KRÜGER "Prüfmittel zur elektrischen Prüfung von Leiterplatten für Uhren", Jahrbuch der Deutschen Gesellschaft für Chronometrie, Band 30, 1979, S. 269-276). Solche Prüfvorrichtungen dienen der Prüfung von Leiterplatten oder sonstigen elektrischen, insbesondere elektronischen Bauteilen, um neu hergestellte Leiterplatten oder dergl. vor oder nach ihrer Bestückung für ihre Fehlerfreiheit rasch und einfach überprüfen bzw. durchmessen zu können, wozu der Prüfling an mehreren oder im allgemeinen meist sehr vielen Stellen gleichzeitig durch Federkontaktstifte der Prüfvorrichtung elektrisch kontaktiert wird. Die Prüfstellen sind dabei oft sehr nahe beieinander, und zwar um so näher, je - schmaler die Leiter und je kleiner die Leiterabstände des Prüflings sind. Und zwar dienen derartige Prüfvorrichtungen vielfach dazu, die Leiterbahnen noch unbestückter Leiterplatten auf Kurzschluß zwischen benachbarten Leiterbahnen oder andere Fehler der Leiterbahnen, bspw. Unterbrechungen oder dergl., zu prüfen, bevor sie mit weiteren elektronischen Komponenten bestückt werden.

Bei der Prüfung eines Prüflings werden die freien vorderen Enden, d. h. die Kontaktköpfe der Kontaktbolzen, die insbesondere Kontaktspitzen bilden können, an vorbestimmten Stellen des jeweiligen Prüflings in gutem elektrischen Kontakt mit ihnen angedrückt. Die Andrückkraft liegt meist in einem Bereich von ca. 80 - 500 cN und wird durch die Feder des betreffenden Federkontaktstiftes aufgebracht. Der Federkontaktstift dient also dazu, um mit einer vorbestimmten Stelle des jeweiligen Prüflings in guten elektrischen Kontakt zu kommen und einen elektrischen Leiter geringen elektrischen Durchgangswiderstandes zu bilden. Der Federkontaktstift wird mit seinem rückwärtigen Ende oder rückwärtigen Endbereich in der Prüfvorrichtung normalerweise an einen weiterführenden elektrischen Leiter angeschlossen, welcher normalerweise zu einem Auswerter führt, der bei der Prüfung eines jeden Prüflings nach Anlegen der elektrischen Spannung oder Spannungen die von den Federkontaktstiften mit geleiteten elektrischen Ströme bzw. elektrischen Spannungen dahingehend auswertet, ob der Prüfling elektrisch einwandfrei ist oder nicht.

Damit der Auswerter einwandfrei arbeiten kann, ist es wichtig, daß die ihn mit dem jeweiligen Prüfling elektrisch verbindenden Leiter geringe elektrische Widerstandswerte haben, die in meist relativ engen Grenzen liegen sollten, wobei es umso günstiger ist, je enger diese Grenzen gehalten werden können und je niedriger diese Widerstandswerte sind. Diese Widerstandswerte sind entscheidend abhängig von den Durchgangswiderständen der die elektrischen Leiter mit bildenden Federkontaktstiften. Der elektrische Durchgangswiderstand eines Federkontaktstiftes ist sein ohm'scher Widerstand von dem freien vorderen Ende seines Kontaktbolzens aus bis zu seinem rückwärtigen Anschlußende. Dieser Durchgangswiderstand ist entscheidend abhängig von dem ohm'schen Übergangswiderstand zwischen dem Kolben des Kontaktbolzens und dem den Kolben enthaltenden Zylinder des Zylindergliedes.

Bei den bekannten Federkontaktstiften sind die Gleitflächen der Kolben der Kontaktbolzen kreiszylindrisch. Solche Federkontaktstifte sind im Betrieb oft hunderttausenden oder Millionen von Lastwechseln ausgesetzt, bei denen der Kolben auf der Laufbahn des Zylindergliedes gleitet, mit der Folge, daß hierdurch Abrieb entsteht, der Verschmutzung bewirkt, die den elektrischen Übergangswiderstand zwischen dem Kolbenglied und dem Zylinderglied erhöht. Auch der Verschleiß zwischen dem Kolben und dem Zylinderglied kann den Übergangswiderstand schon für sich selbst erhöhen, bspw. dadurch, indem eine elektrisch besonders gut leitende Außenbeschichtung des Kolbens und/oder der Laufbahn des Zylinders abgetragen wird. Auch kann dieser Verschleiß die Lebensdauer des Federkontaktstiftes beschränken.

Es ist eine Aufgabe der Erfindung, einen Federkontaktstift gemäß dem Oberbegriff des Anspruches 1 zu schaffen, welcher an der oder den beim Gleiten des Kolbens im Zylinderglied vorhandenen Berührungsflächen zwischen dem Kolben und dem Zylinderglied nur äußerst geringem Verschleiß ausgesetzt ist, so daß hier kaum oder nur sehr wenig Abrieb entsteht.

Diese Aufgabe wird erfindungsgemäß durch den Federkontaktstift gemäß Anspruch 1 gelöst.

Die ballige Ausbildung der mindestens einen Gleitfläche des Kolbens, mit der dieser jeweils ausgehend von der vorderen Ruhestellung des Kontaktbolzens, in der dieser zum Zylinder zentriert ist, in der also der Kontaktbolzen koaxial zum Zylinder ausgerichtet oder angeordnet ist, auf der Laufbahn des Zylindergliedes gleiten kann, wirkt sich überraschenderweise in besonders geringem Verschleiß aus. Es entsteht kein oder nur extrem wenig Abrieb. Der Federkontaktstift kann so besonders viele Lastwechsel aushalten und an entsprechend vielen Prüfvorgängen teilnehmen. Auch erhöht sich der elektrische Übergangswiderstand zwischen Kolben und Zylinderglied nicht oder nur relativ langsam mit der Zahl der Lastwechsel. Versuche im Vergleich zu herkömmlichen Federkontaktstiften, die sich von erfindungsgemäßen Federkontaktstiften nur dadurch unterscheiden, daß die Kolbengleitfläche bzw. -flächen nicht ballig ausgebildet sondern kreiszylindrisch ausgebildet war bzw. waren, ergaben für die erfindungsgemäßen Federkontaktstifte wesentlich geringeren Verschleiß und kaum noch Abrieb. Der geringe oder fehlende Abrieb vermindert oder vermeidet auch die Bildung von den elektrischen Übergangswiderstand Gleitfläche/Lauffläche erhöhenden Belägen auf den Gleit-und Laufflächen des Kolbens und Zylinders.

Die ballig ausgebildete Gleitfläche des Kolbens, bzw. wenn er mehrere ballig ausgebildete Gleitflächen aufweist, alle diese Gleitflächen befinden sich zweckmäßig ständig innerhalb des Zylinders.

Bevorzugt kann vorgesehen sein, daß die oder mindestens eine ballig ausgebildete Gleitfläche des Kolbens rotationssymmetrisch ist. Es ist jedoch auch denkbar, daß man in manchen Fällen von der Rotationssymmetrie abweichen kann, bspw. in den Kolben am Umfang im gleichen Zentriwinkel voneinander angeordnete schmale Längsnuten eingearbeitet, die sich in axialen Richtungen erstrecken.

Besonders vorteilhaft ist es, vorzusehen, daß die oder mindestens eine ballig ausgebildete Gleitfläche des Kolbens durch eine Kugelzone des Kolbens gebildet ist.

Eine solche Kugelzone ist besonders einfach und genau herstellbar. Auch zeigt es sich, daß sie ganz besonders geringen Verschleiß ergibt.

In vielen Fällen ist es erwünscht, daß der Kolben im Zylinderglied geradegeführt ist, so daß die in der Ruhestellung des Kontaktbolzens vorliegende Zentrierung zum Zylinder auch bei den axialen Bewegungen des Kontaktbolzens relativ zum Zylinder ständig erhalten bleibt, beide Teile also ständig koaxial zueinander ausgerichtet bleiben. Dies läßt sich auf einfache Weise dadurch erreichen, daß der Kolben zwei im axialen Abstand voneinander angeordnete, ballig ausgebildete Gleitflächen aufweist.

Obwohl die Bildung der Gleitfläche des Kolbens durch eine Kugelzone besonders vorteilhaft ist, sind auch andere ballige Ausbildungen der Gleitfläche möglich. Bspw. kann die ballige Gleitfläche oft zweckmäßig durch einen tonnenförmig, oval, ellipsoidartig oder einer Kugelzone angenäherten konvex gewölbten Bereich des Kontaktbolzens gebildet sein. Bei einer besonders vorteilhaften Ausführungsform ist vorgesehen, daß der Kolben eine einzige ballig ausgebildete Gleitfläche aufweist und ein an ihm angeordneter Schaft des Kontaktbolzens eine Öffnung des Zylindergliedes im Betrieb mit so großem Seitenspiel durchdringen kann, daß im Betrieb der Kontaktbolzen, wenn er sich nicht in seiner vorderen Ruhestellung befindet, in der sein Kontaktkopf unbelastet ist, infolge der einzigen ballig ausgebildeten Gleitfläche quer zu seiner Längsrichtung - schwenken kann zur Selbstzentrierung des Kontaktkopfes des Kontaktbolzens in Vertiefungen, Buchsen oder dergl. von Prüflingen.

In der Zeichnung sind Ausführungsbeispiele der Erfindung dargestellt. Es zeigen:

Fig. 1-4 je einen Federkontaktstift gemäß Ausführungsbeispielen der Erfindung in teilweise gebrochenen und längsgeschnittenen Darstellungen,

Fig. 5 einen vergrößerten Ausschnitt aus Fig. 3.

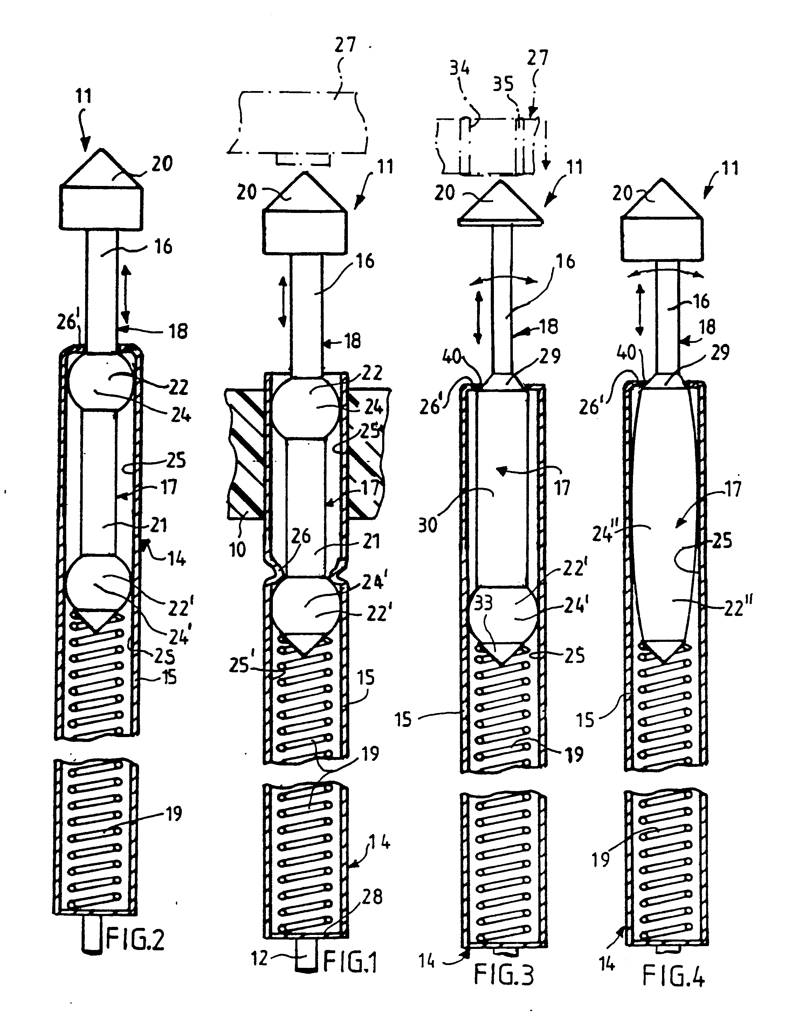

In Fig. 1 ist die ebene Platte 10 eines Prüfadapters einer Prüfvorrichtung für Leiterplatten oder dergl. angedeutet, in welche Platte 10 eine Vielzahl von gleich ausgebildeten Federkontaktstiften, und zwar meist hunderte bis mehrere oder viele tausend Federkontaktstifte fest eingesetzt sein können, von denen ein Federkontaktstift 11 längsgeschnitten dargestellt ist.

Dieser Federkontaktstift 11 besteht aus einem Zylinderglied 14, einem starren oder steifen rotationssymmetrischen Kontaktbolzen 18 und einer den Kontaktbolzen 18 in auswärtiger Richtung belastenden, im Innern des rotationssymmetrischen Zylinders 15 des Zylindergliedes 14 angeordneten, an dem Boden 28 des Zylinders 15 sich abstützenden, vorgespannten Schraubendruckfeder 19. An das rückwärtige Ende des hülsenförmigen Zylinders 15 schließt noch ein im Durchmesser verkleinerter metallischer Stift 12 für den elektrischen Anschluß dieses Federkontaktstiftes 11 an. Alle Teile dieses Federkontaktstiftes sind metallisch. Auch können den elektrischen Übergangswiderstand zwischen dem starren oder steifen Kolben 17 und dem Zylinder 15 verringernde Beschichtungen aus Edelmetallen, Edelmetallegierungen, Nickel oder dergl. vorgesehen sein. Das Mantelrohr des Zylinders 15 ist mit Ausnahme einer Einschnürung 26 kreiszylindrisch. Der gerade massive Kontaktbolzen 18 kann einstückig ausgebildet sein und weist koaxial zueinander den einzigen Kolben 17, einen Schaft 16 und einen vergrößerten, als Kontaktspitze ausgebildeten Kontaktkopf 20 auf, der das ständig außerhalb des Zylindergliedes 14 und damit seines Zylinders 15 befindliche freie vordere Ende des Kontaktbolzens 18 bildet, das dem Inkontaktkommen mit Prüflingen, wie 27, dient. Das Zylinderglied 14 besteht hier aus dem Zylinder 15 und dem an dessen Boden 28 befestigten Stift 12. Der Kontaktbolzen 18 ragt ständig aus dem Zylinder 15 heraus.

Der massive Kolben 17 besteht in diesem Ausführungsbeispiel aus zwei im axialen Längsabstand voneinander angeordneten Kugelschichten 22 bzw. 22' und einem sie verbindenden kreiszylindrischen Verbindungsstab 21. Die Oberflächen der Kugelschichten 22, 22' bilden je eine Kugelzone 24 bzw. 24' desselben Radius. Die die einzelne Kugelschicht 22 bzw. 22' und damit die betreffende Kugelzone 24 bzw. 24' halbierende, die Längsachse des massiven Kontaktbolzens 18 senkrecht schneidende geometrische Ebene ist eine Symmetrieebene der betreffenden Kugelzone 24 bzw. 24' und Kugelschicht 22 bzw. 22'. Jede Kugelzone 24 bzw. 24' ist ein ringförmiger Ausschnitt aus einer geometrischen Kugelfläche. Die Kugelzone 24 bzw. 24' bildet also je eine ballig ausgebildete Gleitfläche mit konstantem Krümmungsradius, mit denen der Kolben 17 im Zylinder 15 gleiten kann, wobei diese Gleitflächen extrem schmale Bereiche der Kugelzonen 22, 22' sind, nämlich die nahezu linienförmigen Bereiche, an denen die Kugelzonen 22, 22' den Zylinder 15 kontaktieren. Die beiden Kugelzonen 24 bzw. 24' des Kolbens 17 befinden sich innerhalb des Zylinders 15 und können auf dessen hier zweigeteilter, am Innenumfang vorgesehenen Zylinderlaufbahn 25, 25' mit geringem Gleitlagerspiel axial gleiten und bilden so die einzigen Gleitflächen des Kolbens 17, die sich also ständig innerhalb des Zylinders 15 befinden. Beide Teillaufbahnen 25, 25' sind kreiszylindrisch und weisen denselben Durchmesser auf. Im Mantel des Zylinders 15 ist eine Einschnürung 26 vorgesehen, die einen nach innen gerichteten Ringbund bildet, der einen Anschlag für die hintere Kugelschicht 22' bildet, so daß die Feder 19 diese hintere Kugelschicht 22' an diesen Anschlag 26 immer dann andrückt, solange sich der Kontaktbolzen 18 in seiner dargestellten Ruhestellung befindet, in der sein Kontaktkopf 20 unbelastet ist. Infolge der beiden Kugelzonen 22, 22' ist der Kontaktbolzen 18 zum Zylinderglied 14 ständig zentriert, so daß die Längsachse des Kontaktbolzens 18 ständig mit der Längsachse des Zylinders 15 zusammenfällt, also der Kontaktbolzen 18 ständig koaxial zum Zylinder 15 angeordnet bleibt.

Der Zylinder 15 ist an seinem der Kontaktspitze 20 benachbarten Ende vollständig offen und die der Kontaktspitze 20 benachbarte vordere Kugelschicht 22 ist in der dargestellten Ruhestellung des Kontaktbolzens 18 noch im Zylinder 15 aber nahe seinem vorderen freien Ende.

Der Kolben 17 ist der einzige Kolben dieses Federkontaktstiftes. Es ist also auch der einzige Kolben, der an der Bewegung des Kontaktbolzens 18 teilnimmt.

Wenn zur Prüfung eines Prüflings 27, bspw. einer Leiterplatte, der Kontaktkopf 20 des Kontaktbolzens 18 des Federkontaktstiftes 11 an eine zu kontaktierende Stelle des Prüflings 27 angedrückt wird und der Prüfling dann den Kontaktbolzen 18 im Zylinder 15 axial nach rückwärts verschiebt, gleiten die beiden Kugelschichten 22, 22' auf der kreiszylindrischen, zweigeteilten Laufbahn 25, 25' des Zylinders 15, und diese Laufbahn 25, 25' bildet so eine Geradführung für diesen, die beiden Kugelschichten 22, 22' und die Verbindungsstange 21 aufweisenden Kolben 17.

Diese beiden Kugelschichten 22, 22' bewirken überraschenderweise, daß der durch das Gleiten des massiven Kolbens 17 im Zylinder 15 auftretende Verschleiß und Abrieb extrem gering ist, und zwar erheblich geringer als wenn bei sonst gleicher Ausbildung des Federkontaktstiftes anstelle der Kugelzonen 24, 24' in vorbekannter Weise kreiszylindrische Kolbenabschnitte vorhanden wären. Es tritt beim dargestellten Federkontaktstift 11 im Zylinder 15 infolge der Kugelschichten 22, 22' praktisch kein Abrieb und damit auch praktisch kaum Verschmutzung auf, die den elektrischen Übergangswiderstand erhöhen würde. Der elektrische Übergangswiderstand zwischen dem Zylinder 15 und dem Kolben 17 ändert sich entsprechend mit der Zahl der Gleiten des Kolbens 17 im Zylinder 15 bewirkenden Lastwechsel nicht oder nur wenig. Auch ist der elektrische Übergangswiderstand sehr gering.

Der Federkontaktstift 11 nach Fig. 2 unterscheidet sich von dem nach Fig. 1 nur durch Versetzung des Anschlages 26 für die Ruhestellung des federbelasteten Kontaktbolzens 18 an das vordere Ende des Zylinders 15, indem hier dieses vordere Ende nach innen umgebördelt ist und so hier einen Anschlag 26' für die vordere Kugelschicht 22 des massiven Kontaktbolzens 18 bildet. Die Laufbahn 25 ist hier ungeteilt.

Der Federkontaktstift 11 nach Fig. 3 und 5 weist ebenfalls ein Zylinderglied 14 und einen einstückigen, massiven Kontaktbolzen 18 und eine diesen Kontaktbolzen belastende, vorgespannte Schraubendruckfeder 19 auf. Der Zylinder 15 des Zylindergliedes 14 ist am vorderen Ende wieder mit einer nach innen gerichteten ringförmigen Bördelung 26' versehen, die einen eine Ringfläche bildenden Anschlag für eine kegelstumpfförmige Ringschulter 29 des geraden massiven Kontaktbolzens 18 für die dargestellte vordere Ruhestellung des massiven Kontaktbolzens 18 bildet. Der Außendurchmesser dieser Ringschulter 29 und damit der Durchmesser eines an sie nach unten anschließenden kreiszylindrischen Stabes 30 ist erheblich kleiner als der Innendurchmesser der einteiligen, kreiszylindrischen Laufbahn 25 dieses Zylinders 15, auf der hier im Betrieb nur die ein-

zige Kugelschicht 22' mit ihrer entsprechend die einzige Gleitfläche dieses Kolbens 17 bildenden Kugelzone 24' mit geringem Gleitlagerspiel gleiten kann, welche Kugelschicht 22' hier am rückwärtigen Ende des Stabes 30 angeordnet ist und ihr Radius ist geringfügig kleiner als der Radius der Laufbahn 25. Die Feder 19 stützt sich wie auch bei den anderen Federkontaktstiften 11 unter Zentrierung an einem rückwärtigen, spitz zulaufenden Ansatz 33 des Kolbens 17 ab. Der Ansatz 33 - schließt an die Kugelschicht 22' koaxial zu ihr an.

Der Innendurchmesser der ringförmigen Bördelung 26' ist hier erheblich größer als der Durchmesser des Schaftes 16, der die durch diese Innenbördelung oder -schulter 26' gebildete kreisrunde Öffnung des Zylinders 15 im Betrieb durchdringen kann. Dies hat zur Folge, daß der Kontaktbolzen 18, wenn er von dem Anschlag 26' abgehoben ist, im ganzen wie in einem Kugelgelenk gelagert verschwenken kann, wie es an einem Beispiel strichpunktiert in Fig. 5 dargestellt ist. Und zwar bildet hierbei die Kugelschicht 22' den "Kugelkopf" dieses "Kugelgelenkes", das jedoch keine Pfanne aufweist, sondern an ihre Stelle tritt die Laufbahn 25 des Zylinders 15. Auch bei diesem Federkontaktstift 11 tritt im Betrieb beim Gleiten der Kugelschicht 22' auf der innenseitigen Laufbahn 25 des Zylinders 15 ebenfalls nur extrem geringer Verschleiß und somit praktisch kein Abrieb auf, so daß der elektrische Übergangswiderstand zwischen Kugelschicht 22' und Zylinder 15 entsprechend über viele Hübe des Kolbens und damit über viele Lastwechsel des Federkontaktstiftes sich nicht oder nur wenig ändert. Auch ist der elektrische Übergangswiderstand zwischen dem Kolben und dem Zylinder 15 trotz der geringen Berührungsfläche sehr niedrig. Ein besonderer Vorteil dieses Federkontaktstiftes 11 ist also auch folgender:

In der dargestellten vorderen Ruhestellung ist der Kontaktbolzen 18 infolge seiner sich verjüngenden, hier kegelstumpfförmigen, zur Längsachse des Kontaktbolzens koaxialen Ringschulter 29 in der Öffnung 40 zentriert und damit zum Zylinder 15 zentriert, so daß der Kontaktbolzen 18 auf einen zu kontaktierenden Prüfling, bevor er ihn kontaktiert, in exakt definierter Stellung ausgerichtet ist, indem in dieser vorderen Ruhestellung des Kontaktbolzens 18 seine Längsachse in die Längsachse des Zylindergliedes 14 fällt, also Kontaktbolzen 18 und Zylinder 15 koaxial zueinander ausgerichtet sind. Wenn die Kontaktspitze 20 des Kontaktbolzens eine Vertiefung oder dgl., bspw. hier eine Kontaktbuchse 35 eines Prüflings 27 kontaktiert und der Kontaktbolzen durch den Prüfling nach unten gedrückt wird, kann sich diese Kontaktspitze 20 dank der Kugelschicht 22' und des großen Seitenspieles des Schaftes 16 in der mittigen Öffnung 40 der Innenschulter 26' unter Schwenken mittels dieses "Kugelgelenkes" in der Bohrung 34 der Buchse 35 zentrieren, was besseren Kontakt zwischen dieser Buchse 35 und der Kontaktspitze 20 und damit hier geringeren elektrischen Übergangswiderstand als bei nicht stattfindender Zentrierung zu bewirken vermag und auch die Beanspruchung des Federkontaktstiftes 11 mindert, das Gleiten des Kolbens 17 erleichtert und den Verschleiß von Kolben 17 und Zylinderlaufbahn 25 noch weiter verringert. Falls also der Kontaktbolzen 18 beim Kontaktieren eines Prüflings 27 außer Fluchtung mit dem Zylinder 15 kommt, also zu ihm dezentriert wird, stellt sich seine zum Zylinder 15 wieder zentrierte, also mit dem Zylinder 15 wieder fluchtende Stellung, in der ihre Längsachsen wieder zusammenfallen, von selbst wieder ein, wenn er durch die Feder 19 gedrückt in seine vordere Ruhelage zurückkehrt. All dies ist also äußerst vorteilhaft.

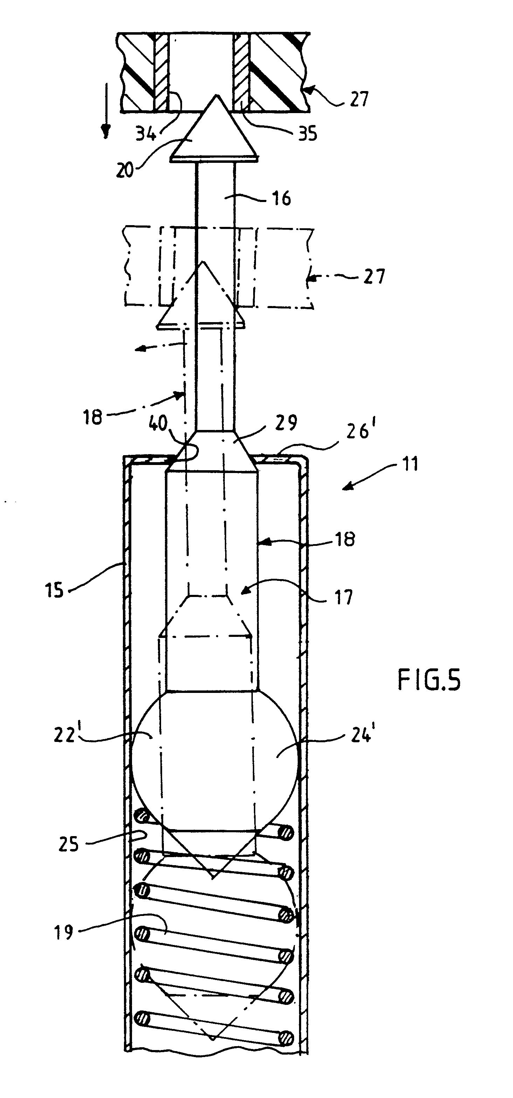

Der massive, starre oder steife Kontaktbolzen 18 des Federkontaktstiftes 11 nach Fig. 4 weist einen einzigen Kolben 17 auf, der einen tonnenförmig gewölbten, balligen Bereich 22" aufweist, der im Betrieb auf der zylindrischen Laufbahn 25 des Zylinders 15 gleiten kann. Der Kolben 17 weist wieder ein spitz zulaufendes rückwärtiges Ende auf, in das die Schraubendruckfeder 19 eingreift. In der dargestellten vorderen Ruhestellung des Kontaktbolzens 18, in der sein Kontaktkopf 20 unbelastet ist, ist seine kegelstumpfförmige Ringschulter 29 zur Zentrierung des Kontaktbolzens 18 zum Zylinder 15 an die Innenschulter 26' des Zylinders 15 angedrückt, so daß in dieser Ruhestellung die Längsachsen des Kontaktbolzens 18 und des Zylinders 15 und damit des Zylindergliedes 14 zusammenfallen. Das in der vorderen Innenschulter 26' des Zylinders 15 des Zylindergliedes 14 gebildete Durchgangsloch 40 für den Schaft 16 des Kontaktbolzens 18 ist wiederum im Durchmesser erheblich größer als der kreiszylindrische Schaft 16, so daß auch dieser Kontaktbolzen 18 sich im Betrieb auf Ausnehmungen oder Bohrungen im Prüfling, in die die sich kegelförmig verjüngende Kontaktspitze 20 eindringt, wiederum unter Verschwenken zentrieren kann. Die durch den balligen, tonnenförmigen, zur Längsachse des Kontaktbolzens 18 rotationssymmetrischen Bereich 22" gebildete einzige Gleitfläche 24" dieses Kolbens 17 weist nicht mehr konstanten Krümmungsradius auf. Vielmehr ist der Krümmungsradius in Umfangsrichtung des Kolbens 17 erheblich kleiner als der Krümmungsradius in den durch die Längsmittelachse des Kontaktbolzens 18 bestimmten geometrischen Symmetrieebenen des Bereiches 22". Letzterer Krümmungsradius kann konstant sein oder sich über die Länge des Bereiches 22" in vorbestimmter Weise ändern. Wenn der Kontaktbolzen 18 durch einen Prüfling weiter in den Zylinder 15 hineingedrückt wird, hebt sich die Ringschulter 29 von der Innenschulter 26' des Zylinders 15 ab und nunmehr ist der einzige direkt Kontakt zwischen dem Zylinder 15 und dem Kolben 17 nur noch durch die ballig ausgebildete Gleitfläche 24'' gegeben. Hierdurch ergibt auch dieser Federkontaktstift im Betrieb nur äußerst geringen Verschleiß und kaum Abrieb und optimales Kontaktieren von Prüflingen.

In allen Ausführungsbeispielen sind die massiven Kolben 17 und Schäfte 16 zweckmäßig rotationssymmetrisch. Auch die Kontaktspitze 20 kann rotationssymmetrisch sein, doch kann sie auch von der Rotationssymmetrie abweichende Ausbildung aufweisen, bspw. mit Schneiden versehen sein.

Der Kontaktbolzen 18 bzw. zumindest sein Kolben 17 kann bevorzugt aus beschichtetem oder unbeschichtetem Stahl, besonders günstig rostfreiem Stahl, insbesondere gehärtetem Stahl, vorzugsweise einer Härte von über 400 Vickers, oder aus beschichtetem oder unbeschichtetem, vergütetem Nickel-Beryllium oder beschichtetem oder unbeschichtetem, vergütetem Kupfer-Beryllium bestehen. Das Kupfer-Beryllium bzw. Nickel-Beryllium kann durch Wärmebehandlung zur Vergütung ausgehärtet sein und vorzugsweise eine Härte von über 300 Vickers aufweisen. Wenn eine Beschichtung vorgesehen ist, kann sie vorzugsweise nur aus galvanisch oder chemisch aufgebrachtem Nickel oder Hartnickel bestehen. Oder die Beschichtung kann eine galvanisch oder chemisch aufgebrachte Diffusionssperre aus Nickel oder Hartnickel aufweisen, auf der eine Schicht aus Edelmetall oder Edelmetallegierung aufgebracht ist. Bevorzugt kann es sich bei dem Edelmetall um Gold, Silber, Hartgold, Rhodium, Palladium oder Legierungen dieser Edelmetalle handeln.

Der Zylinder 15 kann vorzugsweise aus einer beschichteten oder unbeschichteten Kupferlegierung, wie Bronze, Messing, Neusilber, vorzugsweise ungehärtetes Kupfer-Beryllium oder dgl., oder beschichtetem oder unbeschichtetem rostfreiem Stahl bestehen. Das Kupfer-Beryllium kann vorzugsweise eine Härte von mindestens 220 Vickers, vorzugsweise von 220 bis 320 Vickers aufweisen. Wenn der Zylinder 15 eine Beschichtung aufweist, kann diese bevorzugt die Laufbahn 25 bilden oder mit bilden, auf die die Gleitfläche 24 bzw. 24' oder 24'' des Kolbens 17 gleiten kann. Die Beschichtung kann ein-oder mehrschichtig sein, bspw. aus galvanisch oder chemisch aufgebrachtem Nickel oder Hartnickel, oder aus Edelmetall oder einer Edelmetallegierung bestehen.

Wenn sie mehrschichtig ist, kann sie vorzugsweise aus einer als Diffusionssperre dienenden Nickel-oder Hartnickelschicht, auf die eine Schicht aus Edelmetall oder einer Edelmetallegierung aufgebracht ist, bestehen. Bei dem Edelmetall bzw. der Edelmetallegierung kann es sich hier vorzugsweise um Silber, Gold, Palladium oder Legierungen dieser Edelmetalle handeln. Die Schichtdicke von Silber kann zweckmäßig maximal 0,005 mm und die von Gold und Palladium zweckmäßig maximal 0,002 mm betragen.

Alle vorerwähnten Hartnickelschichten können vorzugsweise Härten von 400 bis 1200 Vickers aufweisen und Dicken von mindestens 0,002 mm, vorzugsweise von ca. 0,002 bis 0,007 mm aufweisen.

Die Gleitflächen 24,24',24'' der Kolben 17 sind, da ballig ausgebildet, nur äußerst klein. Diese Gleitflächen und/oder die Laufbahn 25,25' des Zylindergliedes 14, auf der die jeweilige Gleitfläche 24, 24' bzw. 24' bzw. 24'' gleiten kann, können unbeschichtet oder bevorzugt mit den elektrischen Übergangswiderstand noch vermindernden und/oder den Verschleiß noch weiter vermindernden Beschichtungen versehen sein. Die Beschichtungen können, wie erwähnt, bspw. zweckmäßig aus Hartnickel, Edelmetallen, Edelmetallegierungen oder aus sonstigen geeigneten, metallische elektrische Leitfähigkeit aufweisendem Stoff oder Stoffen bestehen. Auch kann die Beschichtung mehrschichtig sein, bspw. kann eine innere Schicht aus Hartnickel mit einer dünneren äußeren Schicht aus Edelmetall, bspw. Gold überzogen sein. Bei einem im Versuch untersuchten Federkontaktstift, der im Prinzip wie in Fig. 1 dargestellt ausgebildet war, und nach 3 Millionen Lastwechseln noch keinen feststellbaren Abrieb zeigte, bestand der Kontaktbolzen aus mit Hartnickel beschichtetem Stahl und das Zylinderglied aus versilberter Bronze, wobei auch die Laufbahn 25 des Zylindergliedes dünn versilbert war.

Solche Federkontaktstifte werden normalerweise an sogenannten Adaptern oder Prüfadaptern von Testgeräten bildenden Prüfvorrichtungen zum Prüfen der Leiterplatten oder der sonstigen elektrischen oder elektronischen Prüflinge in geringen Abständen in meist sehr großen Anzahlen angeordnet. Die Außendurchmesser der Zylinder 15 der Zylinderglieder 14 der Federkontaktstifte haben nur sehr geringe Durchmesser von bspw. 0,5 bis 2,5 mm, ggf. aber auch noch kleiner oder größer. An solchen Prüfadaptern werden häufig oder meist hunderte oder tausende, oft sogar zehntausende oder hunderttausende solcher Federkontaktstifte in geringen Seitenabständen voneinander angeordnet.

Die Länge solcher Federkontaktstifte ist ebenfalls relativ gering und kann meist im Bereich von etwa 1,5 bis 8 Zentimeter liegen. In manchen Fällen können sie auch kürzer oder länger sein.

In den meisten Fällen ist es besonders zweckmäßig, den Kontaktbolzen 17 einstückig auszubilden. In manchen Fällen kann es jedoch zweckmäßig sein, seinen Kontaktkopf als gesondertes Teil auszubilden, das an dem Schaft 16 oder dgl. des Kontaktbolzens lösbar oder nicht lösbar, bspw. durch Schweißen befestigt wird und so aus anderem Material als der restliche Kontaktbolzen ausgebildet werden kann.

Der das vordere freie Ende des Kontaktbolzens 18 bildende Kontaktkopf kann auch irgendwelche anderen Ausbildungen als dargestellt aufweisen, die für das Kontaktieren von Prüflingen geeignet sind, bspw. mit mehreren Spitzen, mit mindestens einer Schneide oder sonstwie anders ausgebildet sein. Er kann vorzugsweise dicker als der ihn tragende Schaft oder in manchen Fällen auch nur als freies, vorzugsweise zugespitztes oder sonstwie geformtes Ende des Schaftes ausgebildet sein.

Bevorzugt ist vorgesehen, daß bei erfindungsgemäßen Federkontaktstiften der Grundkörper des Kolbens 17 größere Härte, vorzugsweise wesentlich größere Härte als der Grundkörper des Zylinders 15 aufweist, was sich günstig auf noch weitere Senkung des Verschleißes und den Erhalt geringen elektrischen Übergangswiderstandes auswirkt. Der Grundkörper ist dabei der Körper, der im Falle einer Beschichtung diese trägt und im Falle fehlender Beschichtung den unbeschichteten Kolben bzw. Zylinder bildet. Die Härtedifferenz der beiden Grundkörper kann vorzugsweise mindestens 50 Vickers betragen.

**Ansprüche**

1. Federkontaktstift für Prüfvorrichtungen zum Prüfen von elektrischen, insbesondere elektronischen Prüflingen, wie Leiterplatten oder dergl., welcher Federkontaktstift einen metallischen Zylinder aufweist, der einen Innenraum aufweist, in dem der einzige Kolben eines aus dem Zylinder herausragenden, federbelasteten metallischen Kontaktbolzens gleitbar gelagert ist, dessen vorderes, freies Ende dem Inkontaktkommen mit Prüflingen dient, dadurch gekennzeichnet, daß die dem Gleiten auf der Laufbahn (25; 25') des Zylinders (15) dienende, mindestens eine Gleitfläche (24; 24'; 24") des Kolbens (17) ballig ausgebildet ist und daß der Kontaktbolzen (18) zumindest in seiner vorderen Ruhestellung, in der sein vorderes Ende (20) unbelastet ist, zum Zylinder (15) zentriert ist.

2. Federkontaktstift nach Anspruch 1, dadurch gekennzeichnet, daß die ballig ausgebildete Gleitfläche oder mindestens eine ballig ausgebildete Gleitfläche des Kolbens (17) durch eine rotationssymmetrische Kolbenfläche gebildet ist.

3. Federkontaktstift nach Anspruch 1 oder 2, dadurch gekennzeichnet, daß die ballig ausgebildete Gleitfläche oder mindestens eine ballig ausgebildete Gleitfläche (24; 24') des Kolbens (17) durch eine Kugelzone des Kontaktbolzens (18) gebildet ist.

4. Federkontaktstift nach Anspruch 1 oder 2, dadurch gekennzeichnet, daß die ballig ausgebildete Gleitfläche (24') des Kolbens durch einen tonnenförmig, ellipsoidartig, oval oder einer Kugelzone angenähert gewölbten konvexen Bereich des Kontaktbolzens gebildet ist.

5. Federkontaktstift nach einem der vorhergehenden Ansprüche, dadurch gekennzeichnet, daß der Kolben (17) im Zylinder (15) mittels zwei im axialen Abstand voneinander angeordneten, ballig ausgebildeten Gleitflächen (24, 24') geradegeführt ist.

6. Federkontaktstift nach einem der Ansprüche 1 - 4, dadurch gekennzeichnet, daß der Kolben (17) eine einzige ballig ausgebildete Gleitfläche (24'; 24") aufweist und der Kontaktbolzen im Betrieb eine Öffnung (40) des Zylinders (15) mit so großem Seitenspiel durchdringen kann, daß der Kontaktbolzen (18) im Betrieb infolge der ballig ausgebildeten Gleitfläche (24'; 24") quer zu seiner Längsrichtung zur Selbstzentrierung seines vorderen Endes in Vertiefungen, Buchsen (35) oder dergl. von Prüflingen (27) allseitig schwenken kann.

7. Federkontaktstift nach Anspruch 6, dadurch gekennzeichnet, daß der Kontaktbolzen (18) in seiner vorderen Ruhestellung in einer von ihm durchdrungenen Öffnung (40) des Zylinders (15), an deren Wandung er dann anliegt, zentriert ist.

8. Federkontaktstift nach einem der vorhergehenden Ansprüche, dadurch gekennzeichnet, daß der Kolben massiv ausgebildet ist.

9. Federkontaktstift nach einem der vorhergehenden Ansprüche, dadurch gekennzeichnet, daß der Kolben (17), vorzugsweise der Kontaktbolzen einstückig ausgebildet ist.

10. Federkontaktstift nach einem der vorhergehenden Ansprüche, dadurch gekennzeichnet, daß der Kontaktbolzen (18) starr oder steif ausgebildet ist.

11. Federkontaktstift nach einem der vorhergehenden Ansprüche, dadurch gekennzeichnet, daß der Kolben (17) aus beschichtetem oder unbeschichtetem Stahl, vorzugsweise rostfreiem Stahl, Kupfer-Beryllium oder Nickel-Beryllium besteht, wobei im Falle einer Beschichtung diese vorzugsweise aus galvanisch oder chemisch aufgebrachtem Nickel oder Hartnickel, oder aus einer als Diffusionssperre dienenden Nickel-oder Hartnickelschicht und einer auf ihr aufgebrachten Schicht aus Edelmetall, vorzugsweise aus Silber, Gold, Rhodium, oder Palladium, oder einer Edelmetallegierung, vorzugsweise einer Silber-, Gold-, Rhodium- oder Palladiumlegierung bestehen kann.

12. Federkontaktstift nach einem der vorhergehenden Ansprüche, dadurch gekennzeichnet, daß der Zylinder (15) aus beschichtetem oder unbeschichtetem Stahl, Bronze, Messing oder Kupfer-Beryllium besteht, wobei im Falle einer Beschichtung der Laufbahn (25) diese vorzugsweise aus galvanisch oder chemisch aufgebrachtem Nickel oder Hartnickel oder aus Edelmetall oder einer Edelmetallegierung oder einer Schicht aus Nickel oder Hartnickel und einer auf sie aufgebrachten Schicht aus Edelmetall, vorzugsweise aus Silber, Gold oder Palladium, oder einer Edelmetallegierung, vorzugsweise einer Silber-, Gold-oder Palladiumlegierung bestehen kann.

13. Federkontaktstift nach einem der vorhergehenden Ansprüche, dadurch gekennzeichnet, daß der Grundkörper des Kolbens (17) des Kontaktbolzens (18) härter als der Grundkörper des Zylinders (15) ist.

FIG.2

FIG.1

FIG.3

FIG.4

FIG.5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-U-8 417 746 (FEINMETALL GmbH) <br> * Abbildungen 1,5 * | 1 | G 01 R 1/067 |
| A | US-A-4 050 762 (C.K. HINES) <br> * Spalte 4, Zeile 63 - Spalte 5, Zeile 36; Spalte 7, Zeilen 36-44; Abbildungen 1-2,9 * | 1 | |
| A | US-A-3 435 168 (J.S. COONEY) <br> * Abbildungen 2,7 * | 1 | |
| A,D | JAHRBUCH DER DEUTSCHEN GESELLSCHAFT FÜR CHRONOMETRIE, Band 30, 1979, Seiten 269-276, DE; G. KRÜGER: "Prüfmittel zur elektrischen Prüfung von Leiterplatten für Uhren" | | |

RECHERCHIERTE SACHGEBIETE (Int. Cl.4)

G 01 R
H 01 R

Der vorliegende Recherchenbericht wurde für alle Patentansprüche erstellt.

| Recherchenort | Abschlußdatum der Recherche | Prüfer |
|---|---|---|
| DEN HAAG | 26-08-1987 | KUSCHBERT D.E. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82